# EUROPEAN PATENT APPLICATION

(11) **EP 3 101 439 A1**
(43) Date of publication of application: **07.12.2016**
(21) Application number: 16171996.8
(22) Date of filing: 30.05.2016
(51) Int. Cl.: G01R 31/327

(54) **SYSTEM FOR ASSESSING HEALTH INDEX OF SWITCHGEAR**

(30) Priority: 04.06.2015 KR 20150079303
(71) Applicant: LSIS Co., Ltd., Gyeonggi-Do 14119 (KR)
(72) Inventor: LEE, Dohoon, Chungcheongbuk-do 28427 (KR)
(74) Representative: Awapatent AB

(57) **Abstract**

The present invention relates to a system (100) for assessing a health index of a switchgear, and the system comprises a remaining life assessment unit (110) that calculates a remaining life of the switchgear based on a number of uses, a number of operations, and history information of the switchgear; a deterioration degree assessment unit (120) that examines a deterioration degree of the switchgear based on installation environment information and inspection information; a risk degree assessment unit (130) that detects a risk degree of the switchgear based on partial discharge data, insulating gas analysis data, and temperature data; and a health index assessment unit (140) that assesses a health index of the switchgear based on the remaining life information of the switchgear, the deterioration degree information, and the risk degree information of the switchgear.

## Description

### BACKGROUND OF THE INVENTION

### 1. Field of the invention

The present disclosure relates to a system for assessing a health index of a switchgear, and more particularly, to a system for assessing a health index of a switchgear based on information detected from a sensor installed in the switchgear, switchgear history information, and installation environment and inspection information of the switchgear.

### 2. Description of the related art

In recent years, as demand for electric power has continuously increased, demand for electric equipment such as switchgears has also supported high-voltage and large-capacity products as well as has continuously increased. As such electric equipment have supported high-voltage and high capacity products, a possibility of the occurrence of various accidents has increased. An accident at a high-capacity switchgear may cause problems such as a damage of a switchgear or the like as well as cause an interruption of power supply. In order to solve such a problem, a failure on a switchgear should be detected in advance to take an action prior to causing an accident.

In order to detect such a failure, a switchgear in the related art may assess individual status on partial discharge, insulating gas analysis, and temperature, respectively, based on partial discharge data, gas analysis data, temperature data and the like detected by a sensor adhered to an inside of the switchgear. Furthermore, according to a result of the assessment, a warning for each stage such as normal, cautious, critical, dangerous may be notified to a user for each item.

However, the foregoing method for assessing a switchgear in the related art may cause the following problems. In general, a health index or lifespan of a switchgear should be not be decided by one item but collectively determined by various items. However, such a collective (overall) assessment may not be allowed in an assessment method in the related art, thereby causing a problem of reducing reliability on the assessment.

### SUMMARY OF THE INVENTION

The present disclosure is to solve the foregoing problem, and an object of the present disclosure is to provide a system for assigning a weight according to the importance to a plurality of assessment items to collectively determine a health index of a switchgear, thereby assessing a health index of a switchgear capable of assessing a reliable health index.

The objective of the present disclosure may be accomplished by providing a system for assessing a health index of a switchgear, the system comprising:
a remaining life assessment unit that calculates a remaining life of the switchgear based on a number of uses, a number of operations, and history information of the switchgear;
a deterioration degree assessment unit that examines a deterioration degree of the switchgear based on installation environment information and inspection information;
a risk degree assessment unit that determines a risk degree of the switchgear based on partial discharge data, insulating gas analysis data, and temperature data; and
a health index assessment unit that assesses a health index of the switchgear based on the remaining life information of the switchgear calculated by the remaining life assessment unit, the deterioration degree information of the switchgear examined by the deterioration degree assessment unit, and the risk degree information of the switchgear detected by the risk degree assessment unit.

According to a preferred aspect of the present disclosure, the system for assessing a health index of a switchgear may further comprises a display unit that displays a remaining life, a deterioration degree of the switchgear, and a risk degree as a result of assessing the health index.

According to another preferred aspect of the present disclosure, the remaining life assessment unit the remaining life assessment unit comprises: a usage information detection unit that receives a period of use information of the switchgear and a number of operations information of the switchgear to detect a usage of the switchgear; a history information detection unit that receives the manufacturer information of the switchgear, and the use and type information of the switchgear to detect the history information of the switchgear; and a remaining life detection unit that determines a remaining life of the switchgear based on usage information detected from the usage information detection unit and history information detected from the history information detection unit.

According to still another preferred aspect of the present disclosure, the remaining life detection unit is configured to assign a weight according to the importance to a period of use of the switchgear, a number of operations, manufacturer information, the use and type information of the switchgear to determine a remaining life of the switchgear.

According to yet still another preferred aspect of the present disclosure, the deterioration degree assessment unit comprises: an installation environment examination unit that receives installation environment information and the importance information of an electric power line to examine the installation environment of the switchgear; an inspection information detection unit that detects an inspection status of the switchgear based on the body status information of the switchgear, enclosure information, connection material status information, and flooding information; and a deterioration degree examination unit that examines a deterioration degree of the switchgear based on information examined by the installation environment examination unit and inspection information detected by the inspection information detection unit.

According to still yet another preferred aspect of the present disclosure, the deterioration degree examination unit is configured to assign a weight according to the importance to installation environment information, the importance information of an electric power line, body status information, enclosure information, connection material status information, and flooding information, respectively, to examine a deterioration degree of the switchgear.

According to yet still another preferred aspect of the present disclosure, the risk degree assessment unit comprises: a partial discharge analysis unit that analyzes a partial discharge occurring at the switchgear based on data received from a partial discharge detection sensor installed in the switchgear; an insulating gas analysis unit that analyzes an insulating gas leak occurring at the switchgear based on data received from an insulating gas detection sensor installed in the switchgear; a temperature analysis unit that analyzes a temperature of the switchgear based on data received from a temperature sensor installed in the switchgear; and a risk degree detection unit that determines a risk degree of the switchgear based on information received from the partial discharge analysis unit, the insulating gas analysis unit, and the temperature analysis unit.

According to still yet another preferred aspect of the present disclosure, the risk degree detection unit is configured to assign a weight according to the importance to partial discharge data, insulating gas information, and temperature information to determine a risk degree of the switchgear.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a block diagram illustrating an overall configuration of a health index assessment system of a switchgear according to the present disclosure;
FIG. 2 is a block diagram illustrating the configuration of a remaining life assessment unit according to the present disclosure;
FIG. 3 is a block diagram illustrating the configuration of a deterioration degree assessment unit according to the present disclosure;
FIG. 4 is a block diagram illustrating the configuration of a risk degree assessment unit according to the present disclosure;
FIG. 5 is a flow chart illustrating a remaining life assessment method according to the present disclosure;
FIG. 6 is a flow chart illustrating a deterioration degree assessment method according to the present disclosure;
FIG. 7 is a flow chart illustrating a risk degree assessment method according to the present disclosure; and
FIG. 8 is a flow chart illustrating a method of assessing a health index of a switchgear according to the present disclosure.

### DETAILED DESCRIPTION OF THE INVENTION

A preferred embodiment of the present disclosure will be described below with reference to the accompanying drawings.

A health index assessment system of a switchgear according to the present disclosure may assess a health index or remaining life of a switchgear based on various factors.

The health index and remaining life of a switchgear may be assessed by various factors. For example, a health index may be assessed by a risk degree at which the switchgear is exposed such as whether or not a partial discharge has occurred, a status of an insulating gas such as SF₆ within the switchgear (i.e., a status of the filled amount of an insulating gas), a temperature (a temperature of a switchgear), and the like; a history information such as a manufacturer, a type and a date of manufacture of the switchgear; a current deterioration degree of the switchgear, and the like.

There is a difference in the importance among the various items of factors for a health index assessment.

For example, when a partial discharge occurs or an insulating gas is leaked out, a critical accident to the switchgear may occur, and thus they are very important item(of factors) in assessing a health index thereof. On the contrary, an appearance status, an installation period or the like of the switchgear may not be a factor of generating a critical failure to the switchgear though it is an important factor in determining a remaining life thereof. Accordingly, when the switchgear is assessed based on factors of causing critical failures and factors of causing less critical failures equally, it may be impossible to perform an accurate assessment.

According to the present disclosure, a health index of a switchgear may be assessed in consideration of various factors, and a weight of each factor may be imposed according to the importance of each factor, thereby allowing an accurate health index assessment according to the importance.

On the other hand, the health index may be assessed by various factors or items, and the selection of a factor or item for assessment may be carried out in various ways according to the direction of a health index assessment to be assessed. For example, a factor of causing a critical failure to the switchgear may be mainly selected when a health index assessment is carried out around the occurrence of a failure, and a factor such as an appearance status or installation period of the switchgear may be selected when a health index is assessed around a remaining life. Furthermore, the weight of each assessed factor may be set in a different manner according to the direction of a health index assessment.

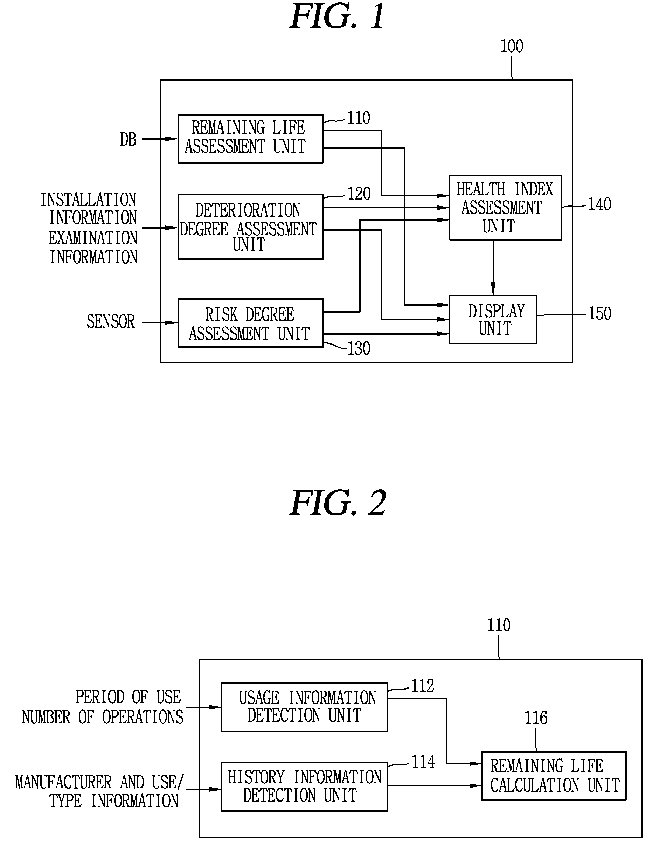

FIG. 1 is a block diagram illustrating the configuration of a health index assessment system of a switchgear according to the present disclosure.

As illustrated in FIG. 1, a health index assessment system 100 of a switchgear comprises a remaining life assessment unit 110, a deterioration degree assessment unit 120, a risk degree assessment unit 130, a health index assessment unit 140, and a display unit 150.

The remaining life assessment unit 110 receives a period of use, a number of operations, and history information of the switchgear for a database (DB) to calculate a remaining life of the switchgear.

The deterioration degree assessment unit 120 examines a deterioration degree of the switchgear based on installation environment information and inspection information.

The risk degree assessment unit 130 determines a risk degree of the switchgear based on partial discharge data, insulating gas analysis data, and temperature data detected from a sensor installed within the switchgear.

The health index assessment unit 140 assesses a health index of the switchgear based on the remaining life information of the switchgear calculated by the remaining life assessment unit 110, the deterioration degree information of the switchgear examined by the deterioration degree assessment unit 120, and the risk degree information of the switchgear determined by the risk degree assessment unit 130.

And a display unit 150 displays a remaining life of the switchgear calculated by the remaining life assessment unit 110, a current deterioration degree of the switchgear examined by the deterioration degree assessment unit 120, and a risk degree determined by the risk degree assessment unit 130 as a result of assessing the health index of the switchgear assessed by the health index assessment unit 140.

Though the health index of the switchgear may be assessed based on various items, the present disclosure assessed a health index based on a remaining life, a deterioration degree, and a risk degree of the switchgear.

In general, the switchgear may have a predetermined lifespan during its initial installation, and the remaining life may reduce as the passage of time. The health index of the switchgear may receive a high assessment as the remaining life of the switchgear is longer, the deterioration degree thereof is lower, and the risk degree thereof is smaller. Accordingly, the health index assessment become worse as the remaining life decreases.

The switchgear may have a predetermined lifespan since time of its initial installation, and thus the remaining life thereof decreases as the period of use has passed. Furthermore, a decrease of the remaining life may not only be dependent on the lifespan of the switchgear itself, but may be influenced by a history information such as a number of operations of the switchgear, a manufacturer of the switchgear, a use of the switchgear, and a type of the switchgear. Accordingly, the present disclosure may calculate a remaining life of the switchgear based on the history information comprising a period of use subsequent to installation of the switchgear, a number of operations of the switchgear, a manufacturer of the switchgear, a use of the switchgear, and a type of the switchgear. Here, the history information such as the period of use, number of operations, the manufacturer information, the use of the switchgear and the type of the switchgear may be stored in a database (DB) and provided to the remaining life assessment unit 110 according to a request of the remaining life assessment unit 110.

The remaining life assessment unit 110 calculates a remaining life of the switchgear based on the history information. Here, in determining a remaining life based on the history information such as the period of use, number of operations, manufacturer of the switchgear, the use of the switchgear and the type of the switchgear, their contributions are different for each history information, and thus a weight is assigned to each history information to determine the remaining life. For example, a factor having the highest proportion for determining the remaining life of the switchgear is the period of use of the switchgear. In other words, the remaining life of a newly established switchgear is a maximum remaining life of the switchgear, and the remaining life decreases in inverse proportion to an increase of the period of use. The number of operations, the manufacturer information, the use of the switchgear, the type of the switchgear and the like are factors for determining the remaining life, but the importance or contribution thereof are small compared to the period of use, and thus the highest weight is assigned to the period of use, and lower weights are assigned to other factors to calculated the remaining life.

The deterioration degree assessment unit 120 examines a deterioration degree of the switchgear. When the deterioration degree of the switchgear increases, the reliability of the switchgear reduces to frequently generate a fault or failure, and thus the deterioration degree of the switchgear is an important factor for the health index assessment of the switchgear. The switchgear deteriorates according to the passage of time subsequent to initial installation. However, a factor for determining the deterioration degree of the switchgear may not be necessarily limited to the period of use, and an environment in which the switchgear is installed may be also a factor for determining the deterioration degree. And the deterioration degree may be determined based on a frequency of usage of the switchgear, so an importance of a power line may be also a factor to determine the deterioration degree.

The deterioration degree assessment unit 120 examines a deterioration degree of the switchgear based on information such as an installation environment and the importance of a power line. Here, the installation environment and the importance of a power line may include subjective factors, and thus a person in charge who installs the switchgear and/or a person in charge who assesses a health index of the switchgear may enter(input) the information including the information of the installation environment and the importance of a power line through an input means such as a keyboard, and a memory (not shown) included in the health index assessment system 100 stores data as objective values, for instance, data such as values indicating an installation environment and a level of the importance of a power line as a result of relatively comparing data such as various installation environments and the importance of various power lines, in a database and then provide it to the deterioration degree assessment unit 120.

Here, the levels of an installation environment and the importance of a power line contributing to a deterioration degree are different, and thus weights are assigned to the information to assess the deterioration degree. For example, in assigning an installation environment and the importance of a power line to assess a deterioration degree, a higher weight may be assigned to the installation environment to assess the deterioration degree in an installation environment in an extreme environment such as a polar or tropical zone or a higher weight may be assigned to the importance of a power line to asses the deterioration degree in case of an extremely important power line.

The risk degree assessment unit 130 assesses a risk degree of the switchgear. The risk of the switchgear may include various risks such as the occurrence of an accident such as an electric shortage fault or ground fault, a malfunction of the switchgear, a disconnection of a power line and the like. For example, a partial discharging may be an importance cause of disconnecting a power line, and insulating gas leakage may be a cause of environmental pollution and personal injury, and an increase of temperature above a threshold temperature set to the switchgear may be a cause of the damage of the switchgear. There may be various factors for causing a failure of the switchgear according to the environment or the type of the switchgear, and they may cause a critical damage to the switchgear or the like during the exposure to a risk, thereby occupying the most important portion during the health index assessment of the switchgear.

A plurality of sensors are installed in the switchgear and information detected from those sensors are entered(input) to the risk degree assessment unit 130, and the risk degree assessment unit 130 determines a risk degree of the entire switchgear based on the entered information. Various sensors may be installed therein. For example, sensors such as a partial discharge detection sensor, a temperature sensor, an insulating gas leakage sensor, and the like may be installed therein. Furthermore, various sensors may be installed according to an environment in which the switchgear is installed or the like.

Here, each of the information received from the sensors may have different risk degrees respectively, and thus the risk degree assessment unit 130 may assign a different weight to the received information to determine a risk degree of the switchgear.

A remaining life of the switchgear calculated by the remaining life assessment unit 110, a deterioration degree of the switchgear assessed by the deterioration degree assessment unit 120, and a risk degree of the switchgear determined by the risk degree assessment unit 130 are entered to the health index assessment unit 140, and the health index assessment unit 140 assesses a health index of the switchgear based on the entered information. In other words, the remaining life of the switchgear, the deterioration degree of the switchgear and the risk degree of the switchgear are collectively determined to assess a health index of the switchgear.

Here, weights are assigned to the remaining life of the switchgear, the deterioration degree of the switchgear and the risk degree of the switchgear, and the health index assessment unit 140 may perform an accurate health index assessment of the switchgear based on the weight (importance) for each item(factor).

The display unit 150 displays a remaining life of the switchgear, a deterioration degree of the switchgear, a risk degree of the switchgear, a result of assessing a health index of the entire switchgear, and the like. Moreover, factors for calculating a remaining life of the switchgear, for example, various information including a period of use (years and months), a number of operations, a manufacturer information of the switchgear, and a use and a type of the switchgear, and weights for those factors may be displayed on the display unit 150.

Furthermore, information generated by a user's visual inspection and input such as factors for assessing a deterioration degree of the switchgear, for example, an installation environment of the switchgear, a status of the body, a status of the enclosure, a status of the connection material, and whether or not the body is flooded, and weights for those factors may be displayed on the display unit 150.

Furthermore, factors for determining a risk degree of the switchgear, for example, information such as partial discharge, temperature, insulating gas leakage and the like, and weights for those factors may be displayed on the display unit 150.

As described above, according to the present disclosure, the switchgear assessment system may assign a weight to each item to assess a remaining life, a deterioration degree, and a risk degree, and then assess a health index of the switchgear based on them. Accordingly, it may be possible to allow the assessment of a collective health index including the weight other than the assessment of a simple health index.

FIGS. 2 through 4 are views illustrating the detailed configuration of the remaining life assessment unit 110, the deterioration degree assessment unit 120 and the risk degree assessment unit 130, respectively.

As illustrated in FIG. 2, the remaining life assessment unit 110 comprises a usage information detection unit 112, a history information detection unit 114, and a remaining life calculation unit 116.

The usage information detection unit 112 receives the information of a period of use and a number of operations of the switchgear from a database to determine the amount of use of the switchgear.

The history information detection unit 114 receives the manufacturer information of the switchgear and the use and type information of the switchgear from a database to generate (create) the history information of the switchgear based on the received information.

The remaining life calculation unit 116 calculates a remaining life based on the usage information and history information provided by the usage information detection unit 112 and history information detection unit 114.

The usage information detection unit 112 may receive information on items such as a manufacture year, a period of use (i.e, used months), a manufacturer, a use and a type of the switchgear from a database to determine a current usage (amount of use) of the switchgear based on those information. Here, the usage information detection unit 112 may assign a weight according to the importance to the received information (input information) for each item to generate (create) usage information based on information to which the weight is assigned.

The history information detection unit 114 may receive information on a manufacturer, a type, a use and the like of the switchgear from the database to generate history information of the switchgear based on those information. Here, the history information detection unit 114 may assign a weight according to the importance to the received item to generate history information based on information to which the weight is assigned.

Table 1 is a table illustrating an example of weights assigned to each item in the usage information detection unit 112 and history information detection unit 114.

**[Table 1]**

| Assessment item | Period of use | Number of operations | Manufacturer information | Type and use |
|---|---|---|---|---|
| Weight | 50% | 10% | 30% | 10% |

As illustrated in Table 1, there are a period of use of the switchgear and a number of operations of the switchgear for items used to determine a usage (amount of use) in the usage information detection unit 112, and there are manufacturer information and the type and use of the switchgear for items for generating history information in the history information detection unit 114.

Here, a weight for each item is a weight according to the importance in assessing the remaining life, respectively. For example, as illustrated in Table 1, a weight for the period of use of the switchgear is about 50%, a weight for a number of operations of the switchgear is 10%, a weight for the manufacturer information of the switchgear is 30%, and a weight for the type and use of the switchgear is 10%. The weights herein are shown as percentages as weights in case where the total assessment weights of the remaining life assessment unit 110 is 100%. Of course, the weight may be shown as an absolute value (independent value) other than a relative percentage with respect to the total assessment weights of the remaining life assessment unit 110.

In assessing the remaining life, the most important factor is the period of use of the switchgear. In general, the switchgear has a predetermined lifespan, and the remaining life is reduced according to the passage of the period of use. The predetermined lifespan is reduced according to the passage of the period of use regardless of an external environment or a number of uses of the switchgear, and thus is the most important factor for assessing the remaining life. Accordingly, as illustrated in Table 1, the weight of a period of use of the switchgear is the highest (50%) compared to those of the other items.

Furthermore, the weight of the manufacturer information for assessing a remaining life of the switchgear is 30%, and the number of operations and the type and use of the switchgear are 10%, respectively.

On the other hand, in Table 1, though only items set to the usage information detection unit 112 and history information detection unit 114 are input, according to the present disclosure, items input to the usage information detection unit 112 and history information detection unit 114 may not be necessarily limited to only those items disclosed in Table 1, and may be set in various ways according to the assessment purpose or environment of the switchgear and health index. Furthermore, the weight of each item may be also set in various ways according to a condition such as the assessment purpose, environment or the like.

The remaining life calculation unit 116 calculates a remaining life of the switchgear based on information detected by the usage information detection unit 112 and history information detection unit 114 according to a weight disclosed in Table 1.

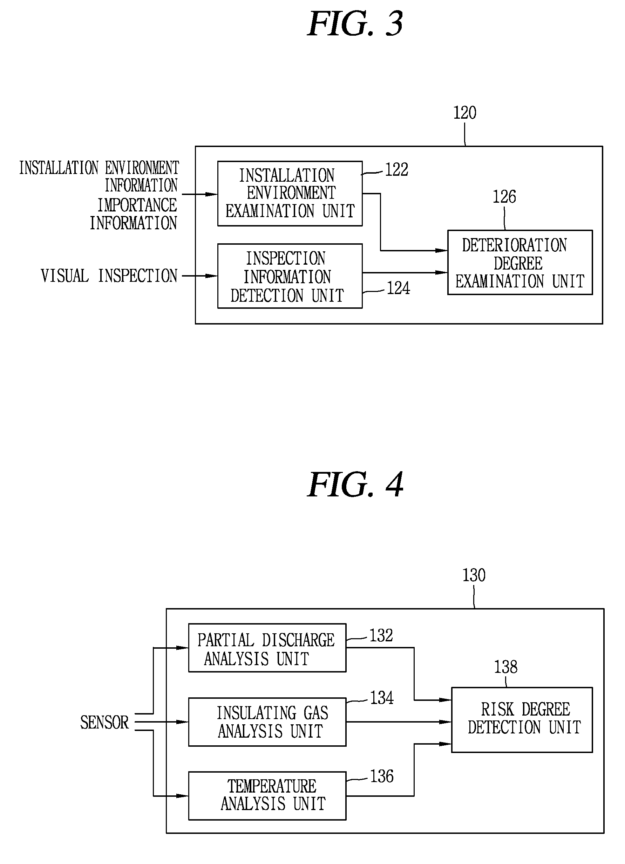

As illustrated in FIG. 3, the deterioration degree assessment unit 120 comprises an installation environment examination unit 122, an inspection information detection unit 124, and a deterioration degree examination unit 126.

The installation environment examination unit 122 receives installation environment information and the importance information of a power line, and determines the current installation environment of the switchgear based on those information. Furthermore, the inspection information detection unit 124 receives the inspection status information of the switchgear, for example, the body status information of the switchgear, enclosure status information, connection material status information, flooding or non-flooding information and the like to determine the current installation environment of the switchgear based on those input information. In particular, the body status information of the switchgear, enclosure status information, connection material status information, flooding or non-flooding information can be generated by allowing a user (operator) to examine the relevant items with his or her naked eyes for the switchgear, and then recording and entering (inputting) them to the inspection information detection unit 124 by the user. Meanwhile, the inspection information may be recorded and entered after carrying out the inspection of the switchgear according to the necessity, and also recorded and entered by periodically carrying out the inspection.

The deterioration degree examination unit 126 assesses a deterioration degree of the switchgear based on the installation environment information of the switchgear provided from the installation environment examination unit 122 and the body status information of the switchgear, enclosure status information, connection material status information, flooding or non-flooding information and the like provided from the inspection information detection unit 124.

Here, the installation environment examination unit 122 and inspection information detection unit 124 may generate history information based on information to which a weight is assigned by assigning the weight according to the importance for each entered item, thereby allowing the assessment of a collective deterioration degree other than a simple deterioration degree of the switchgear.

Table 2 is a table illustrating an example of weights assigned to each item in the installation environment examination unit 122 and inspection information detection unit 124.

**[Table 2]**

| Assessment item | Installation environment | Power line importance | Body status | Enclosure status | Connection material status | Flooding or non-flooding |
|---|---|---|---|---|---|---|
| Weight | 10% | 23% | 15% | 15% | 22% | 15% |

As illustrated in FIG. 2, items assessed by the deterioration degree assessment unit 120 are an installation environment of the switchgear, a status of the body, a status of the enclosure, a status of the connection material, and whether or not the switchgear is flooded, and those weight items are 10%, 23%, 15%, 15%, 22% and 15%, respectively. The weight for each item merely represents an example, and may be set in various ways according to an external environment or assessment purpose of the switchgear.

Furthermore, items entered to the installation environment examination unit 122 and inspection information detection unit 124 to be used for the assessment may not be necessarily limited to items disclosed in Table 1, and may be added and deleted in various ways according to the assessment purpose of the switchgear and health index.

As illustrated in FIG. 4, the risk degree assessment unit 130 comprises a partial discharge analysis unit 132, an insulating gas analysis unit 134, a temperature analysis unit 136, and a risk degree detection unit 138.

The partial discharge analysis unit 132 analyzes a partial discharge generated on the switchgear based on data received from a partial discharge detection sensor such as a ultra high frequency (UHF) sensor, a high frequency sensor, a resistive sensor, an inductive sensor, or the like installed in the switchgear. In other words, the partial discharge analysis unit 132 may compare data received from a partial discharge detection sensor with at least one preset reference data to analyze a partial discharge.

The insulating gas analysis unit 134 analyzes an insulating gas leakage occurring at the switchgear based on data received from an insulating gas detection sensor installed on the switchgear.

Furthermore, the temperature analysis unit 136 analyzes a current temperature of the switchgear based on data received from a temperature sensor installed on the switchgear..

The partial discharge detection sensor detects a partial discharge generated on the switchgear to enter (input) a detection signal to the partial discharge analysis unit 132, and the partial discharge analysis unit 132 compares data according to the corresponding detection signal with at least one preset reference data to determine whether or not a partial discharge has been generated. Here, the ultra high frequency sensor may be used for the partial discharge detection sensor.

The insulating gas detection sensor detects a concentration of an insulating gas contained within the switchgear to enter the measured result to the insulating gas analysis unit 134, and the partial discharge analysis unit 132 determines whether or not there is an insulating gas leakage within the switchgear based on the input concentration of the insulating gas and at least one preset reference concentration, for example by comparing them.

The temperature sensor measures a temperature of the switchgear, and enter the measured temperature of the switchgear to the temperature analysis unit 136. The temperature analysis unit 136 compares the input temperature with at least one preset reference temperature, and determines that a risk has occurred on the switchgear when the measured temperature is higher than the preset reference temperature. Here, according to a preferred embodiment of the present disclosure, an ultrasonic sensor may be used for the temperature sensor.

The risk degree detection unit 138 determines a risk degree of the switchgear based on partial discharge analysis information analyzed by the partial discharge analysis unit 132, insulating gas information analyzed by the insulating gas analysis unit 134, and a temperature analyzed by the temperature analysis unit 136.

Here, weights are assigned to the information from the partial discharge analysis unit 132, the insulating gas analysis unit 134 and the temperature analysis unit 136 by the risk degree detection unit 138 according to the importance to the entered items to determine a risk degree by information to which the weights have been assigned, thereby allowing the assessment of a collective risk degree according to the importance other than a simple risk degree according to the items.

Table 3 is a table illustrating an example of weights assigned to each item in the risk degree detection unit 138.

**[Table 3]**

| Assessment item | Partial discharge | Temperature | Insulating gas |
|---|---|---|---|
| Weight | 35% | 30% | 35% |

As illustrated in Table 3, the risk degree detection unit 138 determines a risk degree based on the result of partial discharge analysis received from the partial discharge analysis unit 132, wherein a weight of the partial discharge with respect to the total risk degree is 35%.

Furthermore, the risk degree detection unit 138 determines a risk degree based on the result of insulating gas analysis received from the insulating gas analysis unit 134, wherein a weight of the insulating gas leakage with respect to the total risk degree is 35%.

In addition, the risk degree detection unit 138 determines a risk degree based on the result of temperature analysis received from the temperature analysis unit 136, wherein a weight of the temperature with respect to the total risk degree is 30%.

However, the weights for each item may merely represent an example, and be set in various ways according to the external environment, assessment purpose and the like of the switchgear. Furthermore, items for assessing a risk degree may be also set in various ways according to the assessment purpose of the switchgear and health index.

Hereinafter, a health index assessment method of a switchgear will be described in more detail with reference to the accompanying drawings.

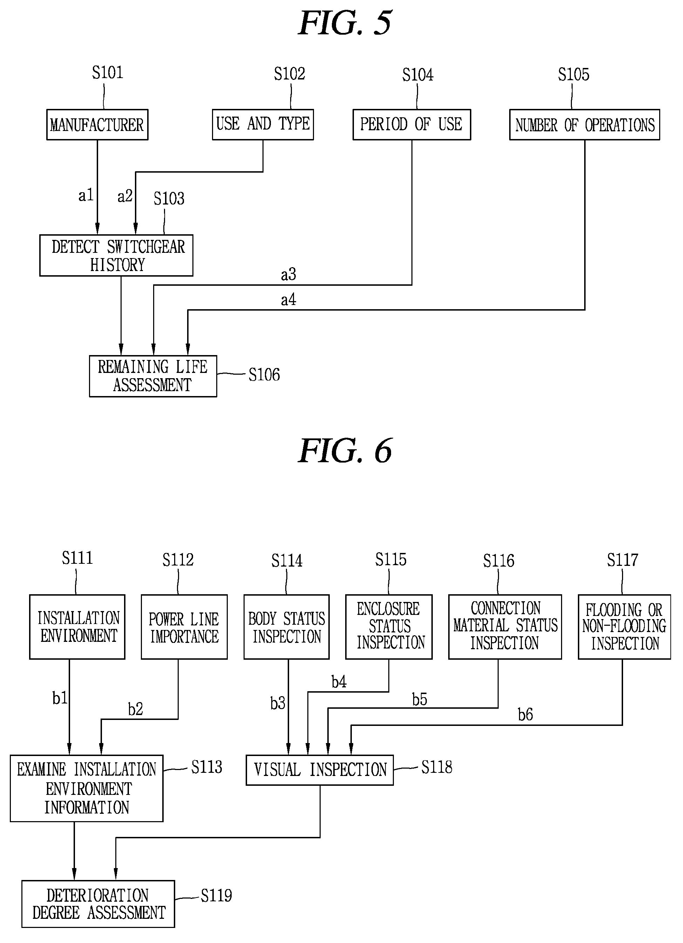

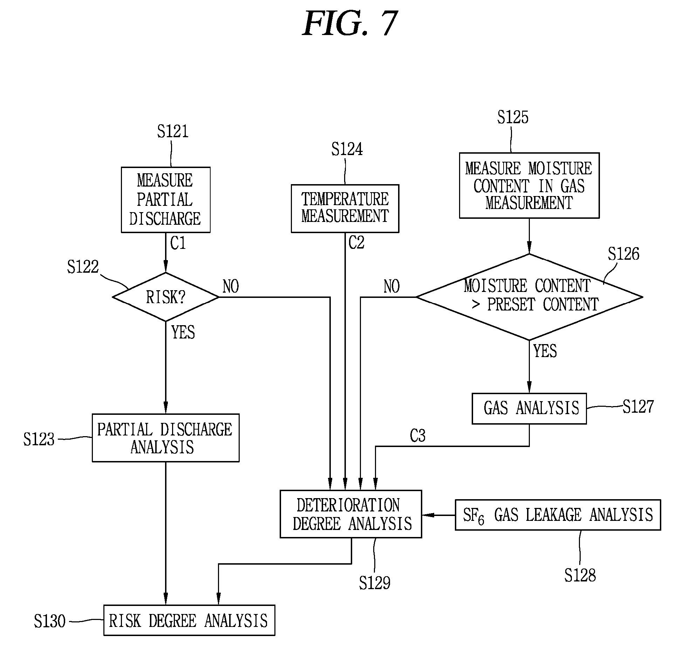

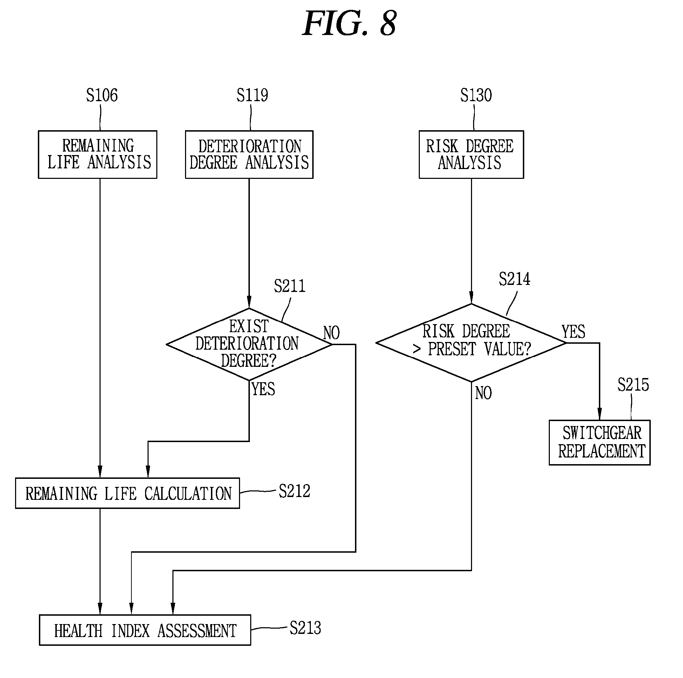

FIGS. 5 through 8 are flow charts illustrating a method of assessing a health index of a switchgear, wherein FIG. 5 is a flow chart illustrating a method of assessing a remaining life, and FIG. 6 is a flow chart illustrating a method of assessing a deterioration degree, and FIG. 7 is a flow chart illustrating a method of assessing a risk degree, and FIG. 8 is a flow chart illustrating a method of collectively analyzing the assessed remaining life, deterioration degree and risk degree to finally determine a health index of the switchgear.

A method of assessing a health index determines it in a collective manner based on a remaining life, a deterioration degree and a risk degree, and thus a method of assessing a remaining life, a method of assessing a deterioration degree, a method of assessing a risk degree and a method of assessing a health index are not separately divided but one consecutive method, however, for the sake of convenience of explanation, they are separately illustrated on the drawings.

As illustrated in FIG. 5, first, the history information detection unit 114 of the remaining life assessment unit 110 detects the history information of the switchgear based on the manufacturer information and use/type information of the switchgear stored in a database (S101, S102, S103). Here, the history information detection unit 114 assigns weights (a1, a2), respectively, to the manufacturer information and use/type information of the switchgear. The weights (a1, a2) may be shown as percentages or absolute values. When they are shown as percentages, the weights of the manufacturer information and use/type information may be set to 30% and 10%, respectively, as illustrated in Table 1, but the weights may be changed according to the necessity. For example, the history information detection unit 114 may adjust the weights of the manufacturer information and use/type information to a range of 25%≤a1≤35% and 5%≤a2≤15%, respectively.

Subsequently, the remaining life calculation unit 116 calculates a currently remaining life of the switchgear based on the period of use information and number of operations of the switchgear stored in the database and the detected history information of the switchgear (S104, S105, S106). Here, the usage information detection unit 112 assigns weights (a3, a4) to the period of use information and number of operations of the switchgear, respectively. When the weights are shown as percentages, the weights of the period of use information and number of operations of the switchgear may be set to 50% and 10%, respectively, as illustrated in Table 1, but the weights may be changed according to the necessity. For example, the usage information detection unit 112 may adjust the weights of the period of use information and number of operations of the switchgear to a range of 45% ≤ a3 ≤ 55% and 5% ≤ a4 ≤ 15%, respectively.

As illustrated in FIG. 6, the installation environment examination unit 122 of the deterioration degree assessment unit 120 examines installation environment information based on the installation environment information and power line importance information of the switchgear (S111, S112, S113). Here, the installation environment examination unit 122 assigns weights (b1, b2) to the installation environment information and power line importance information of the switchgear, respectively. The weights (b1, b2) may be shown as percentages or absolute values. When they are shown as percentages, the weights of the installation environment information and power line importance information of the switchgear may be set to 10% and 23%, respectively, as illustrated in Table 2, but the weights may be changed according to the necessity. For example, the installation environment examination unit 122 may adjust the weights of installation environment information and power line importance information of the switchgear to a range of 7%≤b1≤13% and 20%≤b2≤26%, respectively.

Subsequently, the inspection information detection unit 124 detects an inspection status of the switchgear based on a body status information of the switchgear, an enclosure status information, a connection material status information, and flooding or non-flooding information input by the user (operator) to detect the overall inspection information of the switchgear (S114, S115, S116, S117, S118). Here, the body status, enclosure status, connection material status, and flooding or non-flooding are inspected by an operator with his or her naked eyes, and thus inspection information detected by the inspection information detection unit 124 is inspection information input by an inspector.

On the other hand, the inspection information detection unit 124 assigns weights (b3, b4, b5, b6) to a body status, an enclosure status, a connection material status, and flooding or non-flooding, respectively. The weights (b3, b4, b5, b6) may be shown as percentages or absolute values. When they are shown as percentages, the weights of the body status, enclosure status, connection material status, and flooding or non-flooding of the switchgear may be set to 15%, 15%, 22% and 15%, respectively, as illustrated in Table 2, but the weights may be changed according to the necessity. For example, the inspection information detection unit 124 may adjust the weights of the body status, enclosure status, connection material status, and flooding or non-flooding of the switchgear to a range of 12%≤b3≤18%, 12%≤b4≤18%, 19%≤b5≤25% and 12%≤b6≤18%, respectively.

The deterioration degree examination unit 126 assess a total deterioration degree of the switchgear based on installation environment information received from the installation environment examination unit 122 and a result of the visual inspection received from the inspection information detection unit 124 (S119).

As illustrated in FIG. 7, a partial discharge sensor installed in the switchgear detects a partial discharge, and the partial discharge analysis unit 132 of the risk degree assessment unit 130 determines whether the detected partial discharge is in an ignorable range (S121, S122). When there exists a risk a result of the determination, the partial discharge analysis unit 132 analyzes a partial discharge of the switchgear based on the measured partial discharge result (S123).

Then, the temperature analysis unit 136 of the risk degree assessment unit 130 measures a temperature of the switchgear based on data received from a temperature sensor installed on the switchgear (S124).

Furthermore, the insulating gas analysis unit 134 of the risk degree assessment unit 130 measures a moisture content in the insulating gas of the switchgear based on data received from an insulating gas detection sensor installed on the switchgear (S125). As a result of the measurement, it is determined that there is no risk for an insulating gas leakage when the moisture content is less than a preset reference content, and determined that there is a risk for an insulating gas leakage when the moisture content is above a preset reference content to analyze the leaked insulating gas (S126, S127). Meanwhile, the insulating gas analysis unit 134 analyzes the leakage of an inert insulating gas such as SF₆ (S128). The inert insulating gas is to maintain the insulation stability of the switchgear, and a risk degree of the switchgear increases according to the leakage of the inert insulating gas.

Then, the temperature analysis unit 136 analyzes a risk degree due to a temperature and an insulating gas based on a temperature measured by the temperature analysis unit 136 and an insulating gas analysis result analyzed by the insulating gas analysis unit 134 (S129), and then the risk degree detection unit 138 assesses a risk degree of the switchgear (S130).

On the other hand, weights (C1, C2, C3) are assigned to the partial discharge, temperature and insulating gas analysis detected by a partial discharge sensor to perform analysis during the foregoing process.

The weights (C1, C2, C3) may be may be shown as percentages or absolute values. When they are shown as percentages, the weights of the partial discharge, temperature and insulating gas leakage of the switchgear may be set to 35%, 30% and 35%, respectively, as illustrated in Table 3, but the weights may be changed according to the necessity. For example, the partial discharge analysis unit 132, insulating gas analysis unit 134 and temperature analysis unit 136 may adjust the weights of the partial discharge, temperature and insulating gas leakage of the switchgear to a range of 30%≤C1≤40%, 25%≤C2≤35% and 30%≤C3≤ 40%, respectively.

As illustrated in FIG. 8, a remaining life is calculated based on the assessed remaining life and deterioration degree assessment (S106, S119, S211, S212). When there exists a deterioration degree in the switchgear by the deterioration degree assessment, a remaining life is calculated in consideration of the deterioration degree. For example, assuming that a remaining life of the switchgear is 15 years by the remaining life assessment and a deterioration degree thereof is 3 years by the deterioration degree assessment (the remaining life and deterioration degree may be also expressed as a number of months), a current remaining life of the switchgear is 12 years by subtracting the deterioration degree from the remaining life.

Furthermore, when a risk degree of the switchgear is equal to or less than a preset risk degree (i.e., threshold risk degree) by a risk degree assessment (S130, S214), the health index assessment unit 140 assesses a final health index of the switchgear based on the calculated remaining life and risk degree (S213).

However, when a risk degree of the switchgear is over a preset risk degree by a risk degree assessment, it causes the damage of the switchgear or the outage of power supply during the operation of the switchgear, and thus suspends the operation of the switchgear (S215).

On the other hand, the present disclosure may assign weights to each item during a remaining life analysis, a deterioration degree analysis and a risk degree analysis to analyze a remaining life, a deterioration degree and a risk degree, but weights may be also assigned to the analyzed remaining life, deterioration degree and risk degree to analyze a final health index. In other words, the importance of the remaining life, deterioration degree and risk degree may be assessed to assign weights thereto with percentages and absolute values, thereby assessing a health index in a more accurate manner.

As described above, the present disclosure may collectively determine a health index of the switchgear through a remaining life analysis, a deterioration degree analysis and a risk degree analysis, and assign weights according to the importance to each item, particularly, which is an element for analyzing the remaining life analysis, deterioration degree analysis and risk degree analysis, respectively, thereby allowing the assessment of an accurate health index.

Various modification examples of the present disclosure, a configuration that can be easily devised based on the present disclosure or the like should be included in the scope of the present disclosure. Accordingly, the rights scope of the present disclosure should not be determined by the foregoing detailed description but determined in accordance with the appended claims.

## Claims

1. A system for assessing a health index of a switchgear, **characterized in that** the system comprising:
a remaining life assessment unit (110) that calculates a remaining life of the switchgear based on a number of uses, a number of operations, and history information of the switchgear;
a deterioration degree assessment unit (120) that examines a deterioration degree of the switchgear based on installation environment information and inspection information;
a risk degree assessment unit (130) that determines a risk degree of the switchgear based on partial discharge data, insulating gas analysis data, and temperature data; and
a health index assessment unit (140) that assesses a health index of the switchgear based on the remaining life information of the switchgear calculated by the remaining life assessment unit (110), the deterioration degree information of the switchgear examined by the deterioration degree assessment unit (120), and the risk degree information of the switchgear detected by the risk degree assessment unit (130).

2. The system of claim 1, further comprising:
a display unit (150) that displays a remaining life, a deterioration degree of the switchgear, and a risk degree as a result of assessing the health index.

3. The system of claim 1, wherein the remaining life assessment unit (110) comprises:
a usage information detection unit (112) that receives a period of use information of the switchgear and a number of operations information of the switchgear to detect a usage of the switchgear;
a history information detection unit (114) that receives the manufacturer information of the switchgear, and the use and type information of the switchgear to detect the history information of the switchgear; and
a remaining life detection unit (116) that determines a remaining life of the switchgear based on usage information detected from the usage information detection unit (112) and history information detected from the history information detection unit (114).

4. The system of claim 3, wherein the remaining life detection unit (116) is configured to assign a weight according to the importance to a period of use of the switchgear, a number of operations, manufacturer information, the use and type information of the switchgear to determine a remaining life of the switchgear.

5. The system of claim 1, wherein the deterioration degree assessment unit (120) comprises:
an installation environment examination unit (122) that receives installation environment information and the importance information of an electric power line to examine the installation environment of the switchgear;
an inspection information detection unit (124) that detects an inspection status of the switchgear based on the body status information of the switchgear, enclosure information, connection material status information, and flooding information; and
a deterioration degree examination unit (126) that examines a deterioration degree of the switchgear based on information examined by the installation environment examination unit (122) and inspection information detected by the inspection information detection unit (124).

6. The system of claim 5, wherein the deterioration degree examination unit (126) is configured to assign a weight according to the importance to installation environment information, the importance information of an electric power line, body status information, enclosure information, connection material status information, and flooding information, respectively, to examine a deterioration degree of the switchgear.

7. The system of claim 1, wherein the risk degree assessment unit (130) comprises:
a partial discharge analysis unit (132) that analyzes a partial discharge occurring at the switchgear based on data received from a partial discharge detection sensor installed in the switchgear;
an insulating gas analysis unit (134) that analyzes an insulating gas leak occurring at the switchgear based on data received from an insulating gas detection sensor installed in the switchgear;
a temperature analysis unit (136) that analyzes a temperature of the switchgear based on data received from a temperature sensor installed in the switchgear; and
a risk degree detection unit (138) that determines a risk degree of the switchgear based on information received from the partial discharge analysis unit (132), the insulating gas analysis unit (134), and the temperature analysis unit (136).

8. The system of claim 7, wherein the risk degree detection unit (138) is configured to assign a weight according to the importance to partial discharge data, insulating gas information, and temperature information to determine a risk degree of the switchgear.
